# EUROPÄISCHE PATENTANMELDUNG

(11) **EP 1 162 629 A1**
(43) Veröffentlichungstag der Anmeldung: **12.12.2001**
(21) Anmeldenummer: 00890268.6
(22) Anmeldetag: 01.09.2000
(51) Int. Cl.: H01B 7/08

(54) **Flachbandkabel**

(30) Priorität: 08.06.2000 EP 00890188
(71) Anmelder: I & T Innovation Technik Vertriebs-Ges.m.b.H., 7000 Eisenstadt (AT)
(72) Erfinder: Adams, Winfried, 71067 Sindelfingen (DE)
(74) Vertreter: Patentanwälte BARGER, PISO & PARTNER

(57) **Zusammenfassung**

Die Erfindung betrifft ein Flachbandkabel, auch elektrischer Flachleiter genannt, im wesentlichen bestehend aus einer flexiblen, elektrisch nicht leitenden Trägerfolie, auf der elektrisch leitende Leiterbahnen vorgesehen sind, die gegebenenfalls einen im wesentlichen rechteckigen Querschnitt aufweisen und die voneinander isoliert sind, d.h. Abstand voneinander aufweisen und durch zumindest eine elektrisch nicht leitende Abdeckfolie, die, mit Hilfe passender Klebstoffe, auf die Trägerfolie und die Leiterbahnen laminiert ist, abgedeckt sind.

Die Erfindung ist dadurch gekennzeichnet, daß die Breiten der Leiterbahnen in einer arithmetischen Folge gestaffelt sind und daß die Abstände zwischen benachbarten Leiterbahnen entweder gleich groß oder ebenfalls nach einer arithmetischen Folge mit gleicher Distanz wie die der Leiterbahnen gestaffelt sind.

In einer Ausgestaltung ist vorgesehen, daß die Kontaktierung der Leiterbahnen unabhängig von ihrer Breite mittels Steckern, beispielsweise Klemmleisten, erfolgt, deren Kontakte äquidistant zueinander im Abstand der Breite der schmälsten Leiterbahn, vermehrt um einen Abstand zwischen den Leiterbahnen, vorgesehen sind.

## Beschreibung

Die Erfindung betrifft Flachbandkabel, auch elektrischer Flachleiter genannt, gemäß dem einleitenden Teil des Anspruches 1. Derartige Flachbandkabel bestehen im wesentlichen aus einer flexiblen, elektrisch nicht leitenden Trägerfolie, auf der Leiterbahnen vorgesehen sind, die einen im wesentlichen rechteckigen Querschnitt aufweisen und daher oft auch Rechteckleiter genannt werden. Diese Leiterbahnen sind voneinander isoliert, d.h. im Abstand voneinander angeordnet und werden durch eine gemeinsame Abdeckfolie, die, mit Hilfe passender Klebstoffe, auf die Trägerfolie und die Leiterbahnen laminiert wurde, abgedeckt.

Derartige Flachbandkabel werden in der Automobilindustrie zunehmend eingesetzt, da sie gegenüber den aus einzelnen Rundkabeln bestehenden Kabelbäumen verschiedene Vorteile beim Handling und bei der Unterbringung anstellen, mit extrem geringer freier Bauhöhe große Vorteile aufweisen.

Nachteilig bei diesen Flachbandkabeln ist, daß zufolge der unterschiedlichen Dimensionierung der einzelnen Leiterbahnen in Abhängigkeit von der von ihnen zu ertragenden Stromstärke, die Kontaktierung kompliziert ist und daß es insbesondere problematisch ist, Verbindungen zu Platinen von Steuergeräten, Stromverbrauchern oder Sensoren, aber auch zu Rundkabeln, wie sie beispielsweise in üblichen Kabelbäumen verwendet werden, zu schaffen. Es ist die Aufgabe der Erfindung, hier eine Lösung anzubieten, die die Kontaktierung derartiger Flachbandkabel vereinfacht.

Erfindungsgemäß ist dazu vorgesehen, bei einem Flachbandkabel gemäß dem einleitenden Teil des Anspruches 1 die Merkmale des kennzeichnenden Teiles des Anspruches 1 zu verwirklichen, nämlich die Breiten der Leiterbahnen in einer arithmetischen Folge zu staffeln, die Abstände zwischen benachbarten Leiterbahnen immer gleich groß oder ebenfalls in einer arithmetischen Folge mit gleicher Differenz wie die Breite der Leiterbahnen gestaffelt zu halten und bevorzugt die Kontaktierung der Leiterbahnen unabhängig von ihrer Breite mittels Steckern, beispielsweise Klemmleisten, durchzuführen, deren Kontakte äquidistant zueinander im Abstand der Breite der schmälsten Leiterbahn, vermehrt um den Grundabstand zwischen benachbarten Leiterbahnen, vorgesehen sind.

Auf diese Weise ist es möglich, schwach belastete und daher schmale Leiterbahnen so anzuordnen und auszubilden, daß sie am Ende des Flachleiters bei dichtester Anordnung so liegen, daß jede dieser Leiterbahnen von einem Kontakt der Klemmleiste erfaßt wird. Die nächstbreitere Leiterbahn wird von zwei Kontakten der Klemmleiste erfaßt, die nächstbreitere von drei usw. usw. Damit erhält man trotz Verwendung einheitlicher Stecker eine an die jeweilige Strombelastung angepaßte Kontaktierung der einzelnen Leiterbahnen. Wenn die Abstände zwischen benachbarten Leiterbahnen nicht dem Grundabstand entsprechen, so sind sie nach einem Raster auszuwählen, der vom Grundabstand ausgeht und zu dem ein ganzzahliges Vielfaches des gleichen Rasterabstandes wie bei den Leiterbahnen gezählt wird. Dadurch bleibt der Vorteil der richtigen Kontaktierung bei äquidistanter Anordnung der Kontakte des Steckers immer erhalten.

Dies ermöglicht auch einen einfachen Übergang auf andere Flachkabel, auf Rundkabel, da dazu nur die einzelnen Kontakte (Pins) des Steckers mit entsprechenden Drähten eines Rundkabels verbunden sein müssen und auf Platinen oder Gerätesockel, auf die der Stecker direkt aufgesetzt werden kann.

Selbstverständlich ist es möglich, zusätzlich zu dieser Breitenstaffelung eine Dickenstaffelung der Leiterbahnen vorzusehen, die aber bevorzugt nicht innerhalb eines Flachbandkabels erfolgt, sodaß bei einem Flachbandkabel nur Leiterbahnen einer Stärke, aber gegebenenfalls unterschiedlicher Breite vorgesehen sind.

In einer Ausgestaltung der Erfindung ist vorgesehen, als Rastermaß 2,54 mm (0,1 Zoll) zu wählen und als Abstand zwischen benachbarten Leiterplatten einen Millimeter zur Schaffung elektrischer Isolierung zu wählen, sodaß die schmälste Leiterbahn eine Breite von 1,54 mm aufweist, die nächste von 2 x 2,54 - 1 mm, die nächste von 3 x 2,54 - 1 mm, etc.. Analog dazu beträgt der Grundabstand zwischen benachbarten Leiterbahnen 1 mm, der nächste 2,54 + 1 mm, der nächste 2 x 2,54 + 1 mm, der nächste 3 x 2,54 + 1 mm, etc.. Dies ermöglicht eine besonders einfache Anbindung an die zumeist verwendeten PCB-Platinen, wie sie insbesondere im Automobilbau, aber auch sonst in der Elektronik zumeist verwendet werden.

Die Erfindung bietet den weiteren Vorteil, daß es durch sie möglich wird, die verwendeten Stecker als Endlosprodukte herzustellen, die zur Verwendung nur mehr an die Breite der jeweils zu kontaktierenden Flachbandkabel angepaßt werden müssen. Die Vielzahl der bisher notwendigen Stecker entfällt somit vollständig, es ist gegebenenfalls nur notwendig, für die unterschiedlich dicken Leiterbahnen unterschiedlich hohe Stecker vorzusehen, die aber beispielsweise durch farbliche Markierung leicht auseinanderzuhalten sind und keinen großen logistischen Aufwand erfordern.

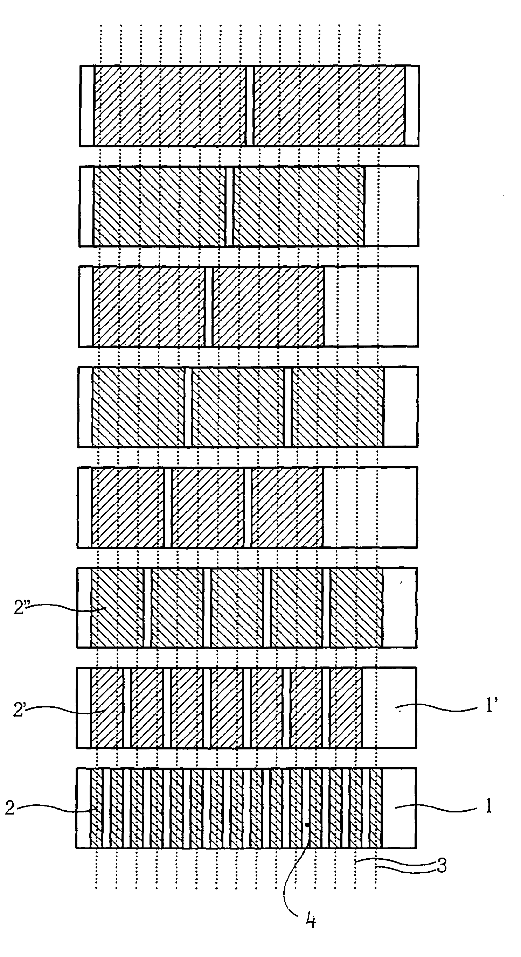

Die Erfindung wird im folgenden anhand der Zeichnung näher erläutert. Die einzige Figur zeigt verschiedene Aufteilungsmöglichkeiten, wobei beim dargestellten Beispiel in jedem der gezeigten Abschnitte der verschiedenen Flachbandkabel 1, 1', etc. immer nur Leiterbahnen 2, 2', 2" einer Breite vorgesehen sind. Dies ist selbstverständlich nicht notwendig, es können in einem Flachbandkabel auch Leiterbahnen unterschiedlicher Breite vorgesehen sein.

Wie aus der Figur hervorgeht, ist es mit äquidistant angeordneten Kontakten eines Steckers oder eines anderen Anschlusses, symbolisiert durch die strichlierten, äquidistanten Linien 3 möglich, die breiten Leiterbahnen 2" öfter zu kontaktieren als die schmalen 2' bzw. 2, sodaß ein entsprechend stärkerer Strom sowohl in der Leiterbahn als auch im Anschluß geleitet bzw. übertragen werden kann, ohne auf die Vorteile eines einheitlichen Maßes der Flachbandkabel oder äquidistanter, untereinander identischer Kontakte beim Stecker verzichten zu müssen.

Die Dicke der einzelnen Leiterbahnen ermöglicht eine weitere Anpassung an die zu leitende Stromstärke, wie aus nachfolgender Tabelle ersichtlich ist, ist es damit möglich, einen großen Bereich an Leiterquerschnitten abzudecken. Es ist dabei auch möglich, Leiterbahnen unterschiedlicher Stärke in einem Flachbandkabel vorzusehen, wenn auch bei großen Unterschieden in der Dicke das Handling des Endlosmaterials möglicherweise problematisch wird.

**Tabelle**

| Rasteranzahl | Breite | Querschnitt bei einer Dicke d von | | | |
|---|---|---|---|---|---|
| | | d=0,15 | d=0,2 | d=0,2273 | d=0,25 |
| 8 | 19,32 | 2,90 | 3,86 | 4,32 | 4,83 |
| 7 | 16,78 | 2,52 | 3,36 | 3,81 | 4,20 |
| 6 | 14,24 | 2,14 | 2,85 | 3,24 | 3,56 |
| 5 | 11,7 | 1,76 | 2,34 | 2,66 | 2,93 |
| 4 | 9,16 | 1,37 | 1,83 | 2,08 | 2,29 |
| 3 | 6,62 | 0,99 | 1,32 | 1,50 | 1,66 |
| 2 | 4,08 | 0,61 | 0,82 | 0,93 | 1,02 |
| 1 | 1,54 | 0,23 | 0,31 | 0,35 | 0,39 |

Die Erfindung ist selbstverständlich nicht auf die beschriebene und dargestellte Ausführungsform beschränkt sondern kann verschiedentlich abgewandelt und verändert werden. So ist es möglich, mehr als eine Träger- bzw. Abdeckfolie zu verwenden und die in der Beschreibung genannten Abmessungen anders zu wählen. Die genannten absoluten Abmessungen sind nur wegen ihrer direkten Kompatibilität mit den handelsüblichen Platinen bevorzugt.

Üblicherweise wird man schon aus Platz- und Kostengründen versuchen, jeweils mit dem Grundabstand zwischen benachbarten Leiterbahnen auszukommen, doch wenn dies nicht möglich oder erwünscht ist, so ist durch die angegebene Staffelung das Erfindungsziel ebenso zu erreichen.

Als Materialien für die erfindungsgemäßen Flachbandkabel können alle Materialien eingesetzt werden, die auch bei herkömmlichen Flachbandkabeln verwendet werden.

## Patentansprüche

1. Flachbandkabel, auch elektrischer Flachleiter genannt, im wesentlichen bestehend aus einer flexiblen, elektrisch nicht leitenden Trägerfolie, auf der elektrisch leitende Leiterbahnen (2,2',2") vorgesehen sind, die gegebenenfalls einen im wesentlichen rechteckigen Querschnitt aufweisen und die voneinander isoliert sind, d.h. Abstand voneinander aufweisen und durch zumindest eine elektrisch nicht leitende Abdeckfolie, die, bevorzugt mit Hilfe passender Klebstoffe, auf die Trägerfolie und die Leiterbahnen laminiert ist, abgedeckt sind, **dadurch gekennzeichnet, daß** die Breiten der Leiterbahnen (2,2',2") in einer arithmetischen Folge gestaffelt sind und daß die Abstände (4) zwischen benachbarten Leiterbahnen bevorzugt gleich groß oder ebenfalls in einer arithmetischen Folge gestaffelt sind.

2. Flachbandkabel nach Anspruch 1, **dadurch gekennzeichnet, daß** die Kontaktierung der Leiterbahnen (2,2',2") unabhängig von ihrer Breite mittels Steckern, beispielsweise Klemmleisten, erfolgt, deren Kontakte äquidistant zueinander im Abstand der Breite der schmälsten Leiterbahn, vermehrt um den Grundabstand zwischen den Leiterbahnen, vorgesehen sind.

3. Flachbandkabel nach Anspruch 1 oder 2, **dadurch gekennzeichnet, daß** die Breite der Leiterbahnen ein ganzzahliges Vielfaches von 2,54 mm beträgt und daß der Abstand zwischen benachbarten Leiterbahnen 1 mm bzw. 1 mm plus ein ganzzahliges Vielfaches von 2,54 mm beträgt.
